# EUROPEAN PATENT APPLICATION

(11) **EP 4 513 527 A2**
(43) Date of publication of application: **26.02.2025**
(21) Application number: 24182807.8
(22) Date of filing: 18.06.2024
(51) Int. Cl.: H01J 37/305, H01J 37/317, H01J 37/02, H01L 21/768, G03F 1/74, G03F 1/78

(54) **GAS MEDIATED SECONDARY ELECTRON GENERATION AND COLLECTION ENHANCEMENT FOR IMPROVED ENDPOINT DETECTION WITH NOBLE IONS FOR CIRCUIT EDIT WITHIN SEMICONDUCTOR WAFERS**

(30) Priority: 25.08.2023 US 202318456309
(71) Applicant: Carl Zeiss SMT GmbH, 73447 Oberkochen (DE)
(72) Inventor: Lewis, Brett, Danvers, 01923 (US); Notte, John, Danvers, 01923 (US); Shakil, Md Mahbubur Rahman, Danvers, 01923 (US); Lombardi, Alexander, Danvers, 01923 (US); Solowan, Hans-Michael, 73447 Oberkochen (DE)
(74) Representative: Carl Zeiss SMT GmbH

(57) **Abstract**

An ion beam system with increased secondary electron yield is provided. The increase of a secondary electron yield is achieved by utilizing during ion beam scanning a combination of at least two individual gases adapted to material compositions present in a semiconductor wafer or lithography mask. The improved system and method can be applied for inspection, circuit edit or repair of semiconductor wafers or lithography masks.

## Description

### Technical field of the invention

The invention provides an ion beam inspection and repair system and method with increased secondary electron emission. With the system and method, inspection and editing of deep structures is improved. The method is applicable for circuit edit within semiconductor wafers or EUV mask repair.

### Background of the Invention

The editing or repairing of microscopic features of semiconductor wafers or semiconductor masks is widely known as circuit edit or mask repair. For example, "circuit edit" refers to a modification of integrated circuits in semiconductor wafers of dies. Circuit editing involves physically modifying integrated circuits to remove, add or otherwise modify materials to alter a semiconductor feature in a semiconductor chip or wafer, enable additional circuit functionality, characterize the operation of the circuit, or correct the function or reliable performance of an integrated circuit. In one specific application, circuit edits are performed during the initial stages of the integrated circuit's life cycle to understand or improve the product's performance. Circuit edits are often performed because they can quickly enable the inexpensive prototyping of a circuit modification before the substantial investment in new lithographic masks and repeating the many steps involved in the wafer fabrication process.

Typically, the methods make use of a radiation beam, for example a Laser beam or a charged particle beam. The radiation beam is focused onto a region of repair, where a layer of material is either removed or deposited. Typically, precursor gases are provided at a repair site to either provide the material for deposition or to bond to the removed material. Sometimes etching gases are used to augment the removal process to make it more effective, more uniform, or more or less selective in the milling of one sample material relative to another. For high resolution requirements, as for modern semiconductor with features down to few nanometers, electron or focused ion beams are utilized for editing or repair operations. Focused Ion Beam (FIB) systems, for example, provide lateral resolutions down to the nanometer regime, and a precise editing or repair of mask or semiconductor features is possible. The pattern of material removal such as trenches or holes of almost arbitrary shape can be formed with high precision. However, the milling rate or rate at which the milled depth increases versus time, depends on the various factors, including the material composition of the sample, the geometry of the milled region, the ion current of the focused ion beam as well as the kinetic energy of the ions, and the mass of the ions. The achieved milling depth may further be subject to several uncertainties, like energy spread of the ions, fluctuations in the ion beam current, fluctuations in material compositions, crystallographic orientation, or sample charging, and the like.

Some focused Ion Beam systems of the prior art use Gallium as the ion species. A FIB beam current can vary over many orders of magnitude, with a conventional gallium FIB this can span from a few pA to several nA. For milling purposes, the areal dosages used by a gallium FIB can be on the order of 1E14 ions/cm^2 or more, for example 1E15, 1E16 or higher ions /cm^2. In another example of the prior art, a gas field ion beam system has been described. US 8,110,114 B2 describes the use of an ion beam system using a gas field ion source and an activating gas for deposition or removal of material for circuit editing. According to US 8,110,114 B2, using a gas field ion source, an unwanted gallium implantation into a semiconductor substrate is avoided. A gas field ion beam system of the prior art for mask repair is described in US 9,236,225 B2.

Requirements for circuit edit and mask repair are becoming more and more demanding. The computer designed patterns of a lithography mask typically have feature sizes comparable to the feature sizes or CD to be produced in the microelectronic circuits on a wafer. Therefore, for microelectronic circuits on a wafer as well as the features on lithography masks, dimensions of features or patterns are becoming ever smaller, for example below 20nm, below 10nm, below 5nm, below 3nm or even less. With these actual and future critical dimensions (CD), also the placement of the semiconductor features or mask features becomes more and more demanding. The pattern placement is typically correlated with the overlay requirement, which is typically specified by a fraction of the CD, for example 1/3 or less of the CD. According to the overlay requirement, the features in different layers within a micro-electronic circuit on a wafer must overlap with even higher precision, with deviations for example below 2nm or even below 1nm.

Semiconductor masks typically have a topography formed by the absorbing structures on top of the mask material. Absorbing structures are typically formed by lithographic processing of an opaque film, for example a chrome film of up to a thickness of tens of nm. Other materials or structures can be employed as well, for example for phase shift masks. For EUV masks, also other absorbers can be employed as for example thin tantalum films or silicon nitride. Features for phase shifting in EUV masks can be buried features, which are covered by a reflective multi-layer stack.

Recently, the number of layers in a typical semiconductor circuit has been increasing. For example, NAND memory devices of processors comprise about 100 layers, and even higher numbers of layers will be achieved in near future. Each layer may be formed as a conducting layer, with conducting features embedded within isolating material. The layers may be separated by isolating layers with some vias or through connections. Isolating material is typically formed by Silicon oxide or Silicon Nitride, while conducting features are formed by doped silicon or metals, comprising for example copper, aluminum, or tungsten. After each layer is formed by a lithography process and etching or implantation, each layer is planarized and a next layer is formed on top of it. The layer thickness can thus be very small, for example 50nm, 20nm, 10nm or even less. A repair site or circuit edit site might be covered by a multi-layer structure comprising up to 100 or even more thin semiconductor layers. The same layered structure applies to EUV masks. EUV masks typically are formed by at least one multilayer-stack comprising at least thirty or more mono-layers of Molybdenum and Silicon. In this case, each layer pair has a thickness of about a half of the EUV wavelength of 13.4nm. Further thin diffusion barrier layers may be formed between the layers.

It is therefore a task of the invention to provide an improved method of end-pointing during ion beam milling. It is a further task of the invention to provide an editing method for a deep structure within or below a multi-layer stack. It is a task of the invention to provide a milling method for a precision-controlled removal of a multi-layer stack above a deep structure. It is a task of the invention to provide a circuit editing or mask repair method with a lateral accuracy of below 1nm and a milling accuracy in depth of below 1nm. It is a task of the invention to provide a circuit editing operation of deep semiconductor structures within highly integrated, multi-layer semiconductor circuits on a chip or wafer. It is a task of the invention to provide a mask repair or mask editing operation of deep structures within an EUV mask. It is a further task of the invention to provide an apparatus capable of performing an editing method for a deep structure within or below a multi-layer stack.

### Summary of the invention

An improved method of ion beam milling and ion beam inspection and an improved ion beam system for inspection and for repair is provided. The improved method utilizes means for an increase of a secondary electron yield. The improved ion beam system is capable for an ion beam inspection or milling with increased secondary electron yield. Thereby, a secondary electron signal is increased during ion beam milling or ion beam inspection, and for example an accuracy of an end-pointing is improved. With the increased secondary electron yield, for example, an accuracy of an editing method for a deep structure within or below a multi-layer stack is improved. For example, a precision-controlled removal of a multi-layer stack above a deep structure is enabled by an ion beam milling with increased secondary electron yield. Thereby, for example, a circuit editing or mask repair with a lateral accuracy of below 1nm and a milling accuracy in depth of below 1nm is enabled.

According to an embodiment, a method of ion beam scanning a semiconductor sample is comprising providing at least two individual gases of a group of gases selected for an increase of a secondary electron yield (short: SE-enhancement gases) by at least two individual gas nozzles to the inspection or repair site. The group of SE-enhancement gases is comprises gases including:
- a first gas formed by an oxidizing or reducing agent selected to change a work function of a material comprised at a surface of the wafer at the inspection or repair site,
- a second gas formed by an inert gas, selected to neutralize a surface charging of the wafer at the inspection or repair site, and
- a third gas formed by an aggressive cleaning agent, selected to chemically remove sputtered material from the surface of the wafer. In an example, the method further comprises providing a third individual gas of the group of SE-enhancement gases by a third individual gas nozzle.

The method is further comprising arranging an inspection or repair site of a wafer at a column axis of an ion beam column and starting a scanning operation of the ion beam over the inspection or repair site. By providing individual SE-enhancement gases by individual gas nozzles into the vacuum at the inspection site and directly above the surface of a wafer, individual reactions of the individual gases are enabled, and a secondary electron yield is enhanced by the combination of the individual actions of the at least two SE-enhancement gases.

In an example, a first gas for SE-enhancement is selected from a group of gases including Hydrogen, Oxygen, water vapor, H2O2, XeF2, NF3, nitric acid, N,N-dimethyl ethanamide, formic acid, ethanol, isopropanol, methyl nitro acetate, ammonia, ammonium Carbamate and nitro-ethanol. In an example, a second gas for SE-enhancement is selected from a group of gases including Nitrogen, Neon, Xenon, Argon, Krypton and Helium. In an example, a third gas for SE-enhancement is selected from a group of gases including XeF2, CI2, Bromine vapor, Iodine vapor, and water vapor.

According to an example of the improved method of ion beam scanning, the at least two gases for SE-enhancement are selected based on a predetermined material composition at an inspection or repair site of a wafer. The material composition of a layer at the inspection or repair site can be determined from CAD information of the mask or wafer or can be determined from a scanning ion beam image obtained during ion beam scanning. The material composition of each of the many layers within a mask or wafer can be different, and the selection and partial pressure of the at least two gases can be adjusted and changed according to the material composition of an actual layer of a mask or wafer. Thereby, for example an end point of a milling operation and stopping the scanning operation of the ion beam over the inspection or repair site can be determined with improved precision.

According to an embodiment, an inspection and repair system is comprising an ion beam column and a group of individual gas nozzles with individual control valves. The group of individual gas nozzles is comprising at least a first and a second individual gas nozzle. The inspection and repair system is further comprising a control module configured to control during use a gas supply of at least a first and a second individual gas for secondary electron enhancement via the at least first and second individual gas nozzles. The control module further comprises a memory storing a set of instructions, and a processor configured to execute the set of instructions to cause the inspection and repair system to perform a method of ion beam scanning with increased secondary electron yield.

The control module is configured for selecting and providing during use at least two individual gases of a group of gases selected for an increase of a secondary electron yield (short: SE-enhancement gases) by at least two individual gas nozzles. The at least first and second individual gas nozzles are connected to at least two gas reservoirs comprising at least two gases selected from a first, a second and a third gas of a group of SE-enhancement gases. The first gas for SE-enhancement can be selected from a group of gases including Hydrogen, Oxygen, water vapor, H2O2, XeF2, NF3, nitric acid, N,N-dimethyl ethanamide, formic acid, ethanol, isopropanol, methyl nitro acetate, ammonia, ammonium Carbamate and nitro-ethanol. The second gas for SE-enhancement can selected from a group of gases including Nitrogen, Neon, Xenon, Argon, Krypton and Helium. The third gas for SE-enhancement can be selected from a group of gases including XeF2, Cl2, Bromine vapor, Iodine vapor, and water vapor.

The inspection and repair system is further comprising a stage control and a stage for arranging an inspection or repair site of a wafer or mask at a column axis of an ion beam column. By providing individual SE-enhancement gases during use by individual gas nozzles into the vacuum at the inspection site and directly above the surface of a wafer, individual reactions of the individual gases are enabled, and a secondary electron yield is enhanced by the combination of the individual actions of the at least two SE-enhancement gases.

In an example, the inspection and repair system is comprising a further gas nozzle to provide a gas selected from a group of gases including PMPCS, Tungsten Hexacarbonyl, dicobalt octa carbonyl, molybdenum hexacarbonyl, and silazane. Thereby, a dedicated coating can be locally generated, for example a Tungsten coating, and an alignment fiducial can be generated, or a repair operation can be performed.

In an example, the ion beam column of the inspection and repair system comprises a gas field ion source. Typical ions used in gas field ion sources are Helium, Neon, Xenon, Argon, but other gases and other kinds of ion sources for focused ion beams are possible as well.

More advantages of the embodiments of the present disclosure will become apparent from the following description in conjunction with the accompanying drawings. The disclosure is not limited to the embodiments and examples, but is also comprising variations, combinations, or modifications thereof. Other embodiments of the invention will be apparent to those skilled in the art from consideration of the specification and practice of the invention disclosed herein.

### Figures

- Figure 1: illustrates an example of an inspection and repair system
- Figure 2: shows an example of a repair site
- Figure 3: shows an example of a method of inspection and repair with an ion beam system with increased secondary electron yield
- Figure 4: illustrates an example of a secondary electron yield according to prior art
- Figure 5: illustrates examples of method employing increased secondary electron yield

Reference will now be made in detail to exemplary embodiments, examples of which are illustrated in the accompanying drawings. Throughout the description same numbers in different drawings represent the same or similar elements unless otherwise represented. The coordinate system is selected with the z-axis parallel to an ion beam, with positive z-direction in the propagation direction of the ion beam. The terms "above" or "below" in this disclosure are relative terms and depend on the orientation of the wafer with respect to the ion beam of an ion beam system.

This disclosure describes certain advantageous techniques for achieving successful circuit edits or mask repairs at the smallest scales. The described techniques involve a focused ion beam system (FIB), and a novel method of using a focused ion beam. Factors such as redeposition and enhanced sputter yield at different angles are factors that experts in this field will be familiar with. Experts in this field are also familiar with enhancement of the milling rate with the addition of etching gases facilitating higher material removal rates or making them more or less selective to different materials or different crystalline orientations.

Generally, a FIB column can for example be a Gallium FIB, with or without a Wien filter or similar mechanism to allow alloy-based sources (such as silicon, gold, etc.), or a FIB with a gas field ion source (GFIS), plasma source or duo-plasmatron with other kinds of ion species, such as Xenon, Oxygen or Argon ions or related technologies (for example "cluster" or "low temperature" ion sources). Generally, a FIB column is used to produce focused ion beams, optionally at different charge states of ions or different ions.

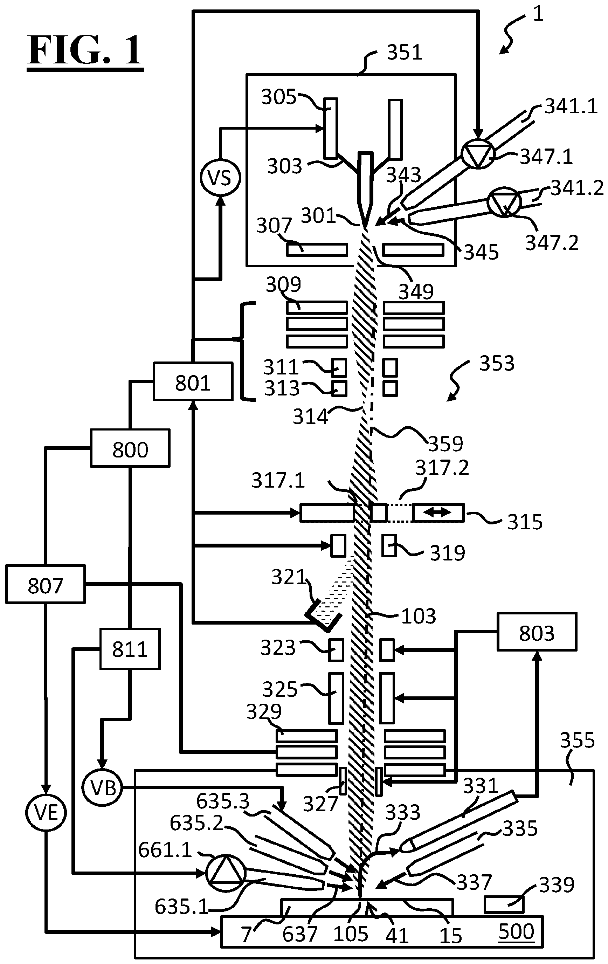

In a **first embodiment,** an inspection and repair system 1 capable of increased secondary electron yield is provided. An example of the inspection and repair system 1 is illustrated in **Figure 1****.** The system 1 comprises a source chamber 351 with a gas field ion source 349 for generating an ion beam 103, an ion beam column 353, and a sample enclosure 355. The inspection and repair system 1 is operated at high vacuum and connected to several vacuum pumps (not shown). In the source chamber unit 351, the source tip 301 is provided and connected via a heating wire 303 to mounting posts 305. The source tip 301 can be formed by few atoms, for example one or three atoms of tungsten. The source chamber 351 is further connected to a vacuum pump (not shown), by which a low vacuum pressure inside the source chamber 351 is maintained. An ion species is generated at the source tip 301. The ion species depends on the gas provided by gas nozzles 341.1 and 341.2 into the evacuated source chamber 351. The source gas nozzles 341 are connected to gas supply units (not shown) for connecting the source chamber to different source gases. The source gas nozzles 341 are configured with precision valves 347.1 and 347.2, by which the partial gas pressures inside the source chamber 351 is adjusted. In the example of figure 1, two source gas supply nozzles 341.1, 341.2 are shown, for providing two different noble gases, for example Helium 343 and Neon 345. However, more than two gas nozzles 341 can be provided and further gases can be used as well, including other noble gases like Argon, or other gases from materials of low atomic mass, for example Lithium or Nitrogen. The ions generated at source tip 301 are accelerated by the extractor electrode to a kinetic energy of up to 30keV. In an example, a source potential is adjusted to +30keV by providing VS = 30kV to the source tip 301. Generally, an ion beam energy can be adjusted to lower energies as well, for example below 20keV, 10 keV, for example 6 keV, 5 keV, 4 keV, or 1 keV.

The gas atoms 343, now ionized and passing the aperture of the extractor electrode 307, are leaving the source chamber 351 through an aperture and are collimated and focused by at least one condenser lens 309 to form an intermediate source image 314. The condenser lens 309 can comprise several lenses, by which for example a magnification of the source image 314 can be adjusted. Thereby, a source current and a resolution can be adjusted. The condenser lens 309 can be configured as an electrostatic lens comprising at least three electrode plates. However, the condenser lens 309 can also be a magnetic lens or a combination of magnetic and electrostatic lenses.

In proximity of the condenser lens 309, two multi-pole elements 311 and 313 are arranged to correct a propagation angle of the ion beam 103 or as first means to compensate aberrations of the ion beam 103. Downstream of the intermediate image 314, the ion beam 103 passes an aperture stop 317.1 arranged on an aperture stop carrier 315. Thereby, a diameter of the ion beam 103 as well as an ion current can further be adjusted. The ion beam 103 traverses a beam deflector 319, by which during use the ion beam 103 can be deflected into a beam dump 321. The beam dump 321 can be configured as a Faraday cup, by which an ion beam current can be measured. Beam deflector 319 and beam dump 321 together have the effect of a beam blanker. With the beam deflector 319 in off mode, the ion beam 103 further propagates through multipole elements 323 and 325, by which during use the ion beam 103 is deflected in a scanning mode across the surface of object 7. The ion beam 103 is further focused by objective lens 329 to form an ion beam focus 105 on the surface of the sample 7. The objective lens 329 can be configured as an electrostatic lens comprising at least three electrode plates. However, the objective lens 329 can also be a magnetic lens or a combination of magnetic and electrostatic lenses.

The sample 7 is mounted in a sample chamber 355 on a sample stage 500, which can be moved and controlled in six degrees of freedom. Such sample stages 500 are known in the art and comprise for example laser interferometers or similar means for position control. Such sample stages 500 further comprise means for precision actuation, such as piezoelectric actuators. A stage 500 can comprise a first stage with long stroke actuators and a second stage with short stroke actuators with precision control within the nm-region. Via the sample stage 500, a repair or inspection site 41 is arranged in proximity of the column axis 359, with the sample surface 15 perpendicular to the column axis 359. During use, the sample stage 500 is configured to hold the sample surface in the focus plane of the ion beam column 353. Via the sample stage 500, a decelerating voltage VE can be provided to the sample 7. With the sample voltage VE, a further adjustment of the focus position is possible. Further, a sample current corresponding to the absorbed charge from the ion beam 103 can be measured. A further calibration sample 339 can be provided on the sample stage 500. The sample enclosure 355 is further connected to a vacuum pump system, comprising such as a turbo-molecular pump, an ion pump, a getter pump, a cryo-pump, a titanium sublimation pump or the like (not shown). The process chamber 355 is provided with a load lock (not shown) for transfer of the sample 7.

Further, a detector 331 is arranged in proximity of the interaction volume of the ion beam 103 with the sample 7. The detector 331 is configured to attract secondary electrons, which are generated by interaction of the ion beam 103 with the sample 7 and are attracted along path 333. Typically, the detector 331 comprises a charged grid to attract electrons, a scintillator to convert charged particles to photons, a light guide, and a photon-detector such as a PMT.

In an example, the inspection and repair system 1 further comprises at least one gas nozzle 335 of a first group of gas nozzles, connected to a reservoir of a precursor gas 337, selected for example for a beam-induced deposition of a material. The precursor gas 337 is for example selected from a group of gases including PMPCS, Tungsten Hexacarbonyl, dicobalt octa carbonyl, molybdenum hexacarbonyl, and silazane.

During use, the components of the repair system 1 are controlled by an operation control unit 800. Some features of the operation control unit 800 are illustrated in further detail. A source control module 801 is responsible for controlling during use a source operation. The source control module 801 is connected to the voltage supply for providing the source voltage VS and extractor voltage (not shown). The source control module 801 is connected to the precision valves 347.1 and 347.2, by which the source gas concentration can be adjusted during use. The source control module 801 is further connected to the condenser lens 309 and the first and second multi-pole elements 311 and 313, by which the formation of the intermediate source image 314 is controlled. Source control unit 801 is further connected to the aperture stop carrier 315, which is configured for a change of the apertures stop 317.1 or 317.2 during use. Source control module 801 is further connected to beam dump 321 and configured for determining and controlling the ion beam current during use.

A focusing control unit 807 is connected to the objective lens 329 and the sample voltage supply. Focusing control unit 807 is configured to adjust the focus spot position of focus spot 105 on the surface of the sample 7. An image acquisition control unit 803 is connected to image sensor 331 and scanning deflectors 323, 325 and 327. During an image acquisition or milling operation, the focused ion beam 103 is scanning deflected in a predetermined scanning path across the surface of the sample 7, and the intensity signal of interaction products 333 is detected for each scanning position and stored in memory locations corresponding to the scanning position in a memory of the image acquisition unit 803. Thereby, image acquisition and scanning are performed during use in synchronized operation and a 2D image of an area of the sample surface is obtained. A first scanning operation of the ion beam 103 is controlled by the third and fourth multi-pole elements 323 and 325. With the combined action of the third and fourth multi-pole elements 323 and 325, a deflection position of the ion beam 103 and an angle of incidence of the ion beam 103 at the surface of the sample 7 can be adjusted. A typical scanning frequency of about 0.01 Hz to 100 Hz can be achieved, corresponding to a pixel dwell time between 0.5µs to 100µs. A fine adjustment of a position of the focus points of the ion beam 103 can be achieved by the fifth deflector 327. The multipole elements 323, 325 and 327 can further act either alone or in combination to adjust or compensate an aberration of the ion beam 103. Thereby, a small probe size with high resolution of below 3nm or even less can be achieved with a position accuracy of below 1nm.

In an alternative example, the objective lens 329 can be formed by a stack of multipole elements, and the focusing control unit 807 is configured to drive each multi-pole element with an offset voltage to generate a lens function and with a plurality of additional individual voltages which are configured to scanning deflect the ion beam 103 and to compensate aberrations of the ion beam 103.

The source control module 801 is configured for a precise control of an ion beam current down to currents below few pA, for example below 1pA, or even below 0.1pA. With the source control module 801, it is further possible to select and adjust ion species during use. According to the disclosure, the repair system 1 is using a gas field ion source (GFIS) with Neon 343 and Helium 345 for circuit edit or repair operation. In an example, the inspection and repair system 1 is configured for using Neon ions for milling and Helium ions for imaging. The source control module 801 is configured for supplying Neon 343 by opening precision valve 347.1 into the source chamber 351 and for providing a source voltage VS to the source tip 1. The inspection and repair system 1 can further be configured to operate at one or more ion species in the ion beam 103.

The inspection and repair system 1 according to the first embodiment further comprises at least one individual gas nozzle 635.1 to 635.3 of a second group of gas nozzles. The individual gas nozzle 635.1 to 635.3 of a second group of gas nozzles are arranged for the individual supply of different gases 637 of a group of SE-enhancement gases separately to the processing chamber 355. In the example shown in Figure 1, the system 1 comprises three gas nozzles 635.1, 635.2 and 635.3. Each individual gas nozzle 635.i is provided with a valve (only one valve 661.1 shown) and connected to at least one reservoir of a specified gas. Each individual gas nozzle 635.i is connected to a voltage supply for providing a bias voltage VB to an individual gas nozzle 635.i. Operation control unit 800 is further connected to inspection control module 811, which is configured to control a gas supply of specified gases 637 via gas nozzles 635.1, 635.2 and 635.3 with control valves 661.1 to 661.3 (only one valve shown in figure 1). Inspection control module 811 is configured to select and provide individual gases 637 to the processing chamber 355 in dependence of an inspection or repair task.

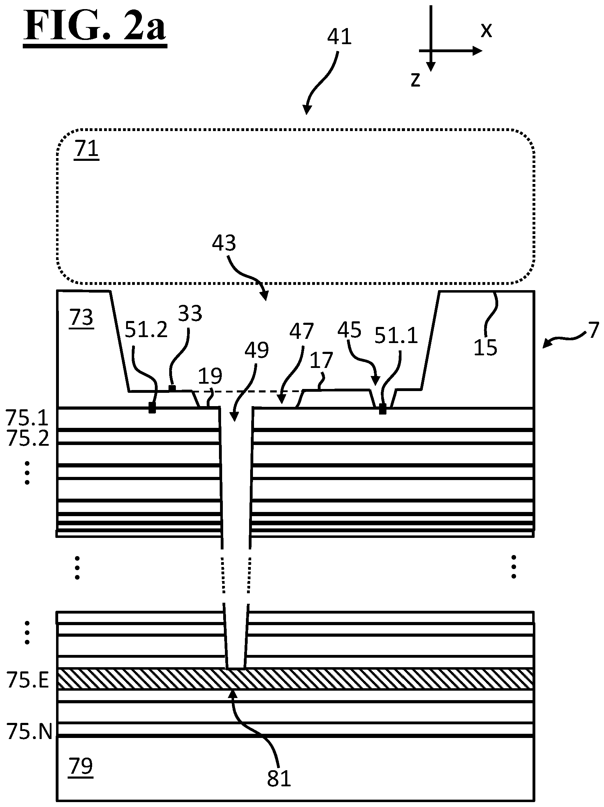

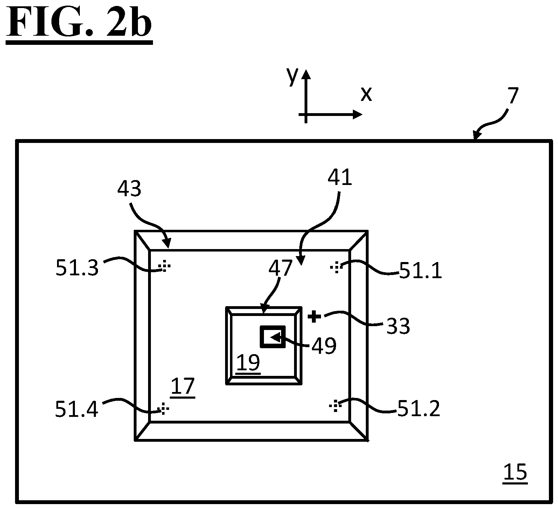

A typical inspection or repair task is illustrated at the example of a circuit edit operation at a semiconductor wafer in **Figure 2****.** A simplified model of a semiconductor wafer 7 with several layers 75.1 to 75.N of different composition is shown in cross section in Figure 2a. For simplicity, the lateral details of the integrated circuits in the layers 75.1 to 75.N are omitted. The figure illustrates an example of a circuit edit operation at a repair site 41 and shows the result of the preliminary steps to prepare the semiconductor wafer 7 at the repair site 41. The multi-layer stack 75.1 to 75.N of the semiconductor wafer 7 may comprise N = 100 or more layers. In the example, a circuit edit or repair location 81 is in repair layer 75.E, which is covered by many layers. A layer number of a deep repair layer 75.E may be at least E > 10, E > 30, E > 50, E > 80 or even E > 100. Each layer of the multilayer structure is comprising for example conductors such as aluminum, tungsten or copper embedded in semiconductor materials such as doped silicon, silicon oxide or silicon nitride. Figure 2b shows a top view of the same repair location 41.

During a repair, a local trench 43 is created into the surface 15 at the area surrounding the edit site 41 to allow for better access. The location of the inspection site 41 and of the trench 43 can be based on different information, for example a failure analysis of the semiconductor wafer 7 or CAD information and can be aided by optical or infrared microscopy which can penetrate the remaining silicon and see navigation fiducials 51.1 and 51.2 before performing the milling operation of trench 43. Navigation fiducials 51 are typically present in the fabricated semiconductor wafer 7. The trench 43 can be created by micro-scale techniques which include laser processing, masked etching using a plasma FIB with etch masks, or FIB operating with high beam currents. The lateral extension of the trench 43 can be several 10µm, for example 50µm 100µm, 200µm or even more. The depth of the trench is selected down to surface 17, which is selected slightly above and nearly exposing the surface 19 of the first semiconductor layer 75.1 of active devices, which are the object of the circuit edit task. The exposed or nearly exposed navigation fiducials 51.1 to 51.4 serve as alignment markers which can be used as location references relative to CAD information (i.e., blueprints) for the subsurface design features of interest. In this way, the semiconductor wafer 7 can be registered with respect to for example CAD information and subsequent activities can be aligned with high precision in lateral X, Y -direction to access the subsurface features at repair location 81 that require editing. In an example, a local trench 45 is formed by precision FIB milling to fully expose a present alignment fiducial 51.1. In an example, a further alignment fiducial 33 is formed close to a lateral position of the repair location 81.

After milling of trench 43 is complete, more precise techniques are used to mill down to the repair location 81. In a first step, a second trench 47 can be formed to expose the surface 19 of the first layer 75.1. Deep milling through the stack of multi-layers 75.1 to 75.E is performed to form deep trench 49 down to the repair location 81. In an example, a precision Ion beam milling with low beam energies and low beam currents is applied. By utilizing low beam energies and low beam currents, the precision milling proceeds slowly, and sub-surface defects are minimized. During the precision milling down to the repair location 81, features present in the layers 75.1 to 75.E are necessarily destroyed. To minimize the unwanted destruction of features present in the layers 75.1 to 75.E, the extent of the deep trench 49 is kept small. According to the example, the depth of the formation of trench 49 by precision milling down to the repair location 81 is determined by an end-pointing method incorporating a monitoring of the increased rate of secondary electrons collected during ion beam milling.

When a charged particle of the ion beam 103 collides with the surface 15 of the substrate 7, energetic interactions between the ion and the atoms in the substrate 7 result in the production of secondary electrons (SE). The number of SEs produced per incident ion is known as the secondary electron yield (SY). Inside the substrate 7, the incident ion transfers energy to electrons all along the ion trajectory as it enters and penetrates deeper into the substrate or sample 7. The ability of these electrons to escape the surface 15 and become secondary electrons depends upon their energy and their probability of escaping to the surface 15 of the sample 7 and overcoming the energetic barrier known as the work function of the material of the sample 7. The number of electrons which escape from the surface of the substrate that is related to the electron emission or electron yield of the material itself, and on the charge state of the sample surface. When irradiating with a positively charged ion, the charge state of the sample 7 tends to build up positively which has the tendency to suppress secondary electron escape. Insulators such as dielectric materials such as SiO2 have the tendency to build up significant positive charge very quickly. Therefore, parts of the secondary electrons generated are not collected by an external electron detector because the positive surface charges prevent secondary electrons from leaving the sample. In prior art, one way of mitigating this accumulated positive charge is by using an electron "flood gun," which is used in parallel with the primary ion beam to introduce a neutralizing negative charge to the sample surface. Electrons provided in excess, however, also might have a negative effect by generating a negative surface charge and by deteriorating the ion beam.

Furthermore, coming along with any ion beam exposure is a sputtering of the sample surface 15. Due to the physical momentum of ions, material is removed from the surface 15 of the substrate or sample 7 and redeposition of sputtered material can occur during ion beam exposure, and sputtered material can interfere with the secondary electrons generated by the ion beam. As an effect, surface sections including material transitions at the surface 15 of the substrate 7 can be obscured by redeposited material during ion beam inspection or milling. For example, redeposition makes end-pointing during ion beam milling difficult.

With the at least first and second gas nozzles 635.1 and 635.2 of the second group of gas nozzles, each connected to gas reservoirs, the inspection and repair system 1 is configured to provide a gas flow of individual different gases prior, concurrently, or alternatingly with an ion-beam exposure or irradiation of the sample surface 15 at an inspection or repair site 41. In an example, the focused ion beam system 1 comprises a focused ion beam column configured for an irradiation of a surface 15 of a sample 7 by a primary charged ion beam (e.g., a focused Neon Ion beam) and at least one individual gas nozzle 635.1 to 635.3 selected from a second group of gas nozzles including
- an individual gas nozzle 635.1 connected to reservoir of a first gas 637.1, selected to change a work function of a material comprised at the surface 15 of the sample 7 at the inspection site 41,
- an individual gas nozzle 635.2 connected to a reservoir of a second gas 637.2, selected to neutralize a surface charging of the sample 7 at the inspection site 41,
- an individual gas nozzle 635.3 connected to a reservoir of a third gas 637.3, selected to chemically remove sputtered material which has been physically sputtered during ion beam inspection or editing from the surface 15 of the sample 7.

The first gas 637.1 is selected from a group of gases including oxidizing or reducing agents such as Hydrogen, Oxygen, water vapor, H2O2, XeF2, NF3, nitric acid, N,N-dimethyl ethanamide, formic acid, ethanol, isopropanol, methyl nitro acetate, ammonia, ammonium Carbamate and nitro-ethanol. The second gas 637.2 is selected from a group of inert gases including Nitrogen, Neon, Xenon, Argon, Krypton and Helium. The third gas 637.3 is selected from a group of gases serving as aggressive cleaning agents, including XeF2, Cl2, Bromine vapor, Iodine vapor, and water vapor.

By providing at least two of the first to third gases 637.1, 637.2 or 637.3 by separated, individual gas nozzles 635.1, 635.2 or 635.3, a mixture of the gases 637.1, 637.2 or 637.3 before exiting the gas nozzles is avoided and a reaction of any pair of the gases 637.1, 637.2 or 637.3 is reduced. Thereby, the desired effect of each of the gases during ion beam milling and inspection is maintained.

The inspection and repair system 1 according to the first embodiment is configured for an ion-beam inspection with an increased secondary electron yield. The inspection and repair system according to the first embodiment is configured for an ion-beam milling with reduced redeposition of sputtered material. With the improved end-pointing according to the increased secondary electron yield, an ion-beam milling operation of the deep trench 49 is stopped at the edit location 81 with higher precision and a damage to the circuit is reduced. The inspection and repair system is configured for an improved operation including at least one of a lowering of a work function of a material, a neutralization of charging of insulators, and reducing of a redeposition of sputtered material. The effects are achieved by providing a combination of individually selected gases 637.1 to 637.3 into the vacuum chamber 355 by separated gas nozzles 635.1, 635.2 or 635.3. Thereby, a reaction between different gases of the combination of selected gases is reduced.

In an example, a positive biasing voltage VB is provided to an individual gas nozzle 635.1 to 635.3. Thereby, secondary electrons are more efficiently extracted from the sample 500. The electrons will be more likely to collide with an individual gas nozzle 635.1 to 635.3 which can then be collected by the detector 331, enhancing the overall signal. In an example, a laser is provided within the process chamber 355, configured to ionize individually selected gases 637.1 to 637.3 above a sample surface 15 for more efficient charge transfer to or from the sample surface 15.

After exposition of the circuit edit location 81, circuit edit activities can be performed. The additive process for example involves the first gas injection system (GIS) or gas nozzle 335 which delivers a volatile precursor which under the presence of the ion beam are condensed to leave conductors or insulators in a precise pattern.

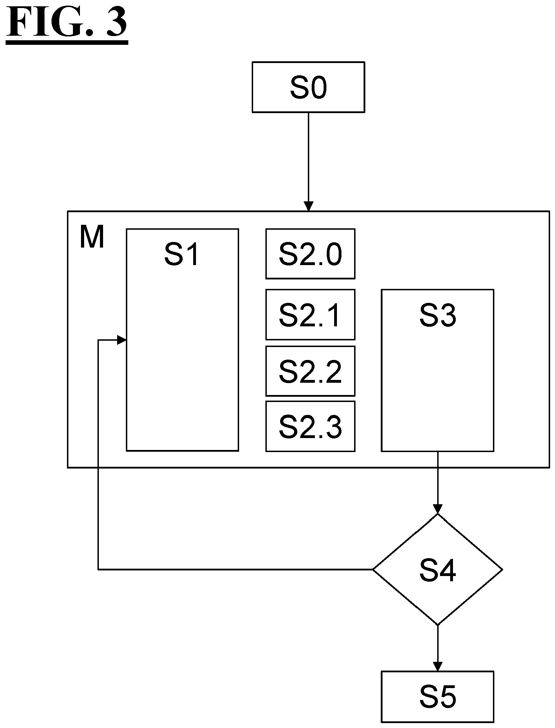

According to a **second embodiment,** a method of operating an ion beam system with increased secondary electron yield is provided. An example of a method of operating an ion beam system with increased secondary electron yield is illustrated in **Figure 3****.** In an initial step S0, an inspection or repair site 41 is aligned at the optical axis of an ion beam system and an inspection or repair site is registered for example at semiconductor features or alignment fiducials present or generated at a wafer or mask surface. In initial step S0, an inspection or repair task is specified. A repair task can for example comprise an editing operation of a semiconductor circuit at edit location 81 in a selected editing layer 75.E, such as a repair of a defect or a void (see figure 2). In an example, a CAD-information about the layer structure and the material compositions included in the multi-layer comprising layer 75.1 to 75.N of a semiconductor wafer 7 at the inspection or repair site 41 is received.

In Step M, an ion beam image acquisition or sputtering is performed in step S1. The ion beam is scanned over the inspection or repair site 41 and, during scanning, secondary electrons are collected, and a layer of material is physically sputtered from the surface 15 of the sample 7. Secondary electrons are generated during ion beam scanning over the surface 15 and collected in step S3. Thereby, for example an image of the surface 15 of the sample 7 is generated.

In step S2.0, gases for increasing a secondary electron yield are selected. The selection is for example based on a known material composition of a sample, for example known from CAD data received during step S0. In an example, the selection is based on an analysis of an image of the surface 15, generated during ion beam scanning from the secondary electron signal collected during step S3. An image of the surface 15 is obtained by the secondary electron signal collected at each dwell point with the ion beam, wherein the secondary electron signal is generally depending on the material composition and topography at each dwell point. The different material compositions of semiconductor wafers or lithography masks is typically known, for example from received information during step S0. A gas selection for example to prevent a redeposition of sputtered material can be performed according to prior known material compositions. A gas selection for example to prevent a redeposition of sputtered material can be performed according to an analysis of an image collected from the surface 15 of the sample 7. A gas selection for example to change a work function of a material can be performed according to at least one of a prior known material composition or an analysis result of image collected from the surface 15 of the sample 7

In steps S2.1 to S2.3, at least one selected gas is provided via one of the gas nozzles 635.1 to 635.3, each connected via a valve to a gas reservoir. For example, in step S2.1, a first gas 637.1 is provided via individual gas nozzle 635.1 to change a work function of a material comprised at the surface 15 of the sample 7 at the inspection site 41. For example, in step S2.2, a second gas 637.2 is provided via individual gas nozzle 635.2 to neutralize a surface charging of the sample 7 at the inspection site 41. For example, in step S2.3, a third gas 637.3 is provided to chemically remove sputtered material which has been physically sputtered during ion beam inspection or editing from the surface 15 of the sample 7. In an example, at least two of the first to third gases 637.1 to 637.3 are individually selected and provided to induce at least one of the desired effects, for example two effects in parallel.

In an example, a combination of at least two gases is selected to enhance the secondary electron signal collected based on the inspection or repair task requirements. For example, a repair task requires a precise end-pointing to stop an ion beam sputtering at a metal line and a certain suite of gases is selected and provided accordingly. For example, a repair task requires to stop an ion beam sputtering at an insulating layer of for example SiO2, SiN2 or a low k dielectric. For example, a composition of gases 637.1 to 637.3 provided by gas nozzles 635.1 to 635.3 is adjusted during ion beam scanning step S1 in dependence of an actual material composition of an actual layer 75.i reached during ion-beam scanning step S1.

In an example, an actual material composition of an actual layer 75.i comprises a metal, such as copper or aluminum. A gas can be selected to trigger oxidation reactions on a metal, which may decrease the work function leading to more secondary electron emission during ion beam exposure in step S1. For example, the crystal structure of metal surfaces can rearrange themselves to accommodate certain gases which are adsorbed. These adsorbates have their own coefficients of emission that may increase the SE signal generated at a metal structure during ion beam exposure in step S1.

In an example, a gaseous vapor, for example water vapor is introduced in the beam interaction region. Thereby, a local surface temperature of a sample is lowered which has the effect of concentrating adsorbed gases for an increased adsorption and the effect of increased secondary electron yield.

In an example, for insulating layers of for example layers comprising SiO2 or a low-k dielectrics as material compositions, other gas or combinations of gases may be chosen. In the presence of insulating materials, gases that induce charge neutralization are more likely to have a positive effect on secondary electron collection. Gas mediated neutralization has the distinct advantage over other forms of charge neutralization, say for example an electron flood gun, of being able to dissipate charge even in high aspect ratio trenches.

Examples of individual gases for combinations of gases are given in table 1.

**Table 1:**

| Material composition | First gas *(Work function)* | Second gas *(Charge neutralize)* | Third gas *(Redeposition removal*/*passivation)* |
|---|---|---|---|
| Copper | formic acid, nitro ethanol | Xenon, Argon, Helium, Neon, Nitrogen, Krypton | Xenon Difluoride |
| Aluminum | Hydrogen Peroxide | Xenon, Argon, Helium, Neon, Nitrogen, Krypton | Chlorine, Iodine, Bromine |
| Insulator layer (SiN, SiO2) | Methyl Nitro Acetate | Xenon, Argon, Helium, Neon, Nitrogen, Krypton | Xenon Difluoride, Oxygen |
| Low-k dielectrics (SiOCH, porous SiO2, organo-silicate glass (OSG), carbon- doped oxide (CDO), fluorinated silicon glass (FSG), polymeric dielectrics | Methyl Nitro Acetate | Xenon, Argon, Helium, Neon, Nitrogen, Krypton | water vapor |
| Tungsten | Hydrogen Peroxide, Ammonia | Xenon, Argon, Helium, Neon, Nitrogen, Krypton | Xenon Difluoride, Iodine, Bromine |
| Tantalum/TaN | Nitric Acid | Xenon, Argon, Helium, Neon, Nitrogen, Krypton | Xenon Difluoride |
| Titanium/TiN | Hydrogen Peroxide | Xenon, Argon, Helium, Neon, Nitrogen, Krypton | Xenon Difluoride |
| Silicon | Nitro Ethanol | Xenon, Argon, Helium, Neon, Nitrogen, Krypton | Chlorine, Iodine, Bromine |

Some selected gases are specific for a selected material. For example, water vapor can be selected as third gas for low-k dielectrics as well as first gas for copper, while Methyl nitro acetate can be selected as a first gas for low-k dielectrics. In a layer with a material composition comprising low-k dielectrics and conducting elements formed by copper, the at least two gases provided can be water vapor and Methyl nitro acetate. Thereby, secondary electron yield is increased and redeposition is reduced for both materials.

Generally, different layers comprising different material compositions require different combinations of selected gases and a frequent adjustment of the selected gases in step S2.0, parallel to ion beam scanning step S1. For example, during ion beam exposure step S1, the combination of selected gases in steps S2.1 to S2.3 is frequently adjusted, including an adjustment of a gas to ion flux ratio, beam current density, and gas replenishment time. The local gas flux selected by step S2.0 and provided by steps S2.1 to S2.3 can be tailored to maximize neutralization of positive or negative surface charges, while minimizing attenuation of the primary ion beam and secondary electrons escaping the surface. In addition, the combination of gases and beam can be alternatingly pulsed for more precise imaging control.

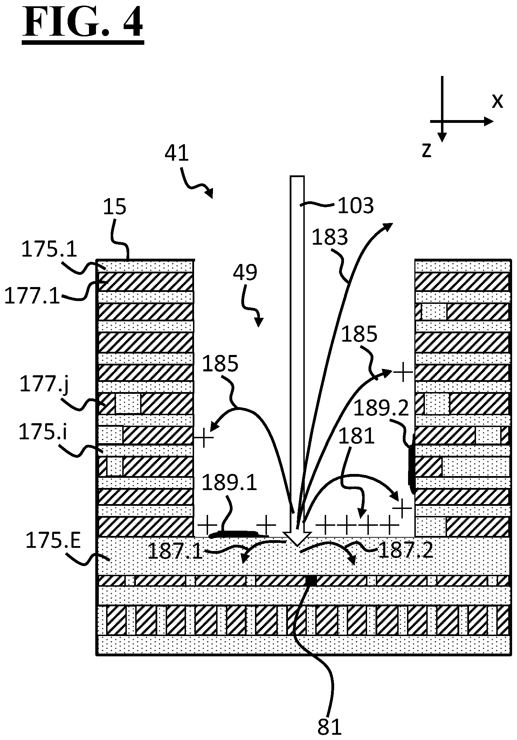

**Figure 4** illustrates an example of the effects during conventional ion beam inspection and milling with ion beam 103. The example shows a repair location 81 in a buried layer below a stack of alternating layers comprising structured layers 175 (with labels 175.1 ... 175.E provided to some layers) and isolating layers 177 (labels 177.1... 177.j provided to some examples). During ion beam scanning over a surface of layer 175.E, secondary electrons is generated. A first group of the secondary electrons escapes the deep trench 49 along escape path 183. A second group of secondary electrons escapes from layer 175.E along paths 185 and is collected for example by the faces of positively charged isolating layers 177 above layer 175.E. A third group of secondary electrons 187 is generated inside layer 175.E, but unable to escape the layer 175.E due to surface charges 181, redeposited milling material 189.1 or a kinetic energy not sufficient to exit the layer 175.E. Furthermore, a first milled material layer 189.1 may be deposited on the interface of layer 175.E and a second milled material layer 189.2 may be deposited on the sidewalls of the deep trench 49 during ion beam milling. The actual milled or inspected layer 175.E of this example is shown as an structured layer 175.E, comprising both of conducting structures formed by a metal or doped silicon and isolating structures such as Silicon-Dioxide.

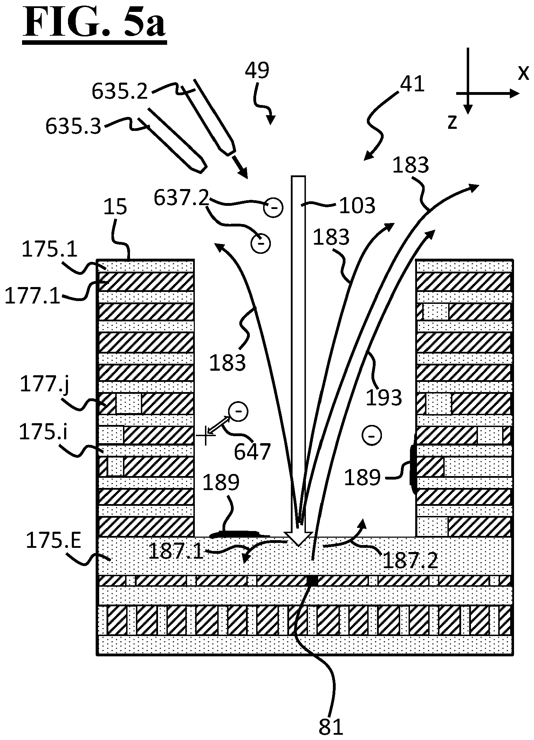

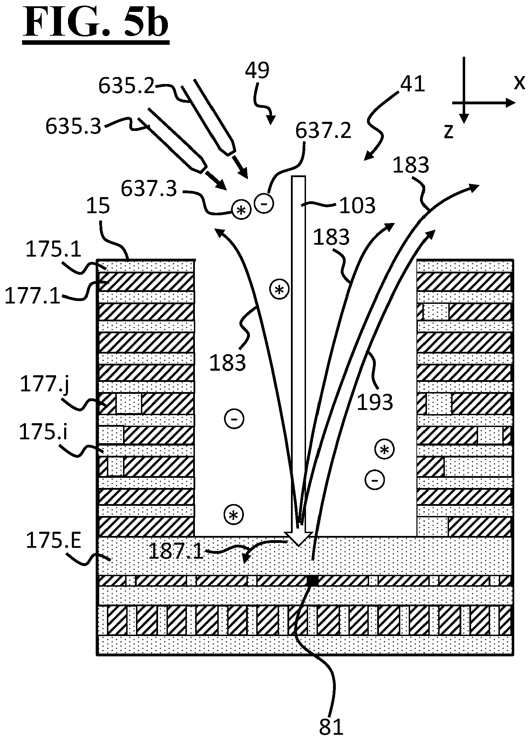

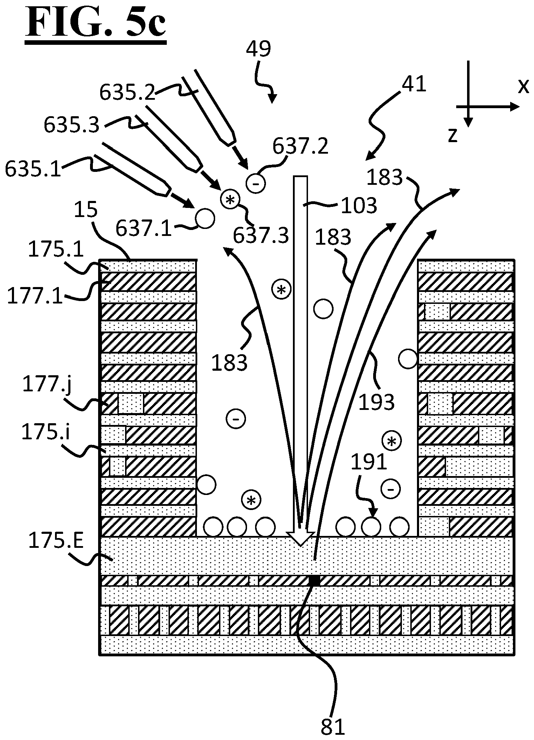

**Figure 5** illustrates the effects of the method according to the second embodiment. Figure 5a illustrates the effect of adding a second gas 637.2 of the group of SE-enhancement gases by the second nozzle 635.2 to the inspection site during ion beam inspection or milling. By providing the second gas 637.2, charges sticking to exposed surfaces of isolators are removed or balanced, and secondary electrons are not attracted to exposed surfaces of isolators anymore (see reference number 647: an ion of a second gas molecule balances the residual charge captured at an isolating layer). Thereby, the secondary electron yield collected by detector 331 (see figure 1) is increased. Furthermore, by removing or balancing charged at the surface of layer 175.E, secondary electrons 187.2 (see also figure 4) now can leave escape layer 175.E. Thereby, the secondary electron yield collected by detector 331 (see figure 1) is increased. The second gas can for example be Nitrogen gas comprising Nitrogen ions.

Figure 5b illustrates the further effect of adding a third gas 637.3 of the group of SE-enhancement gases by the third nozzle 635.3 to the inspection site during ion beam inspection or milling. By providing the third gas 637.3, redeposition of milled material is prevented and no layers of debris of milled material 189 (see figure 4) are built during ion beam inspection or milling. Thereby, for example an image generation or a milling operation is not deteriorated. In presence of copper lines within layer 175.E, the third gas can for example by Nitro ethanol or Xenon difluoride.

Figure 5c illustrates the further effect of adding a first gas 637.1 of the first group of gases by the first nozzle 635.1 to the inspection site during ion beam inspection or milling. By providing the first gas 637.1, a work function of a material is reduced, and a secondary electron yield is increased. By lowering the work function for example by a gas or gas compound 191 sticking to the surface of layer 175.E, even more secondary electrons may escape the layer 175.E. A first gas 637.1 can for example be water vapor.

A mixture of individual gases for increasing secondary electron yield according to the embodiment comprises at least two gases selected from the group of gases including first, second and third gases. The example of figure 5b with a second and third gas is one example, while other combinations of at least two gases comprising a first and second or first and third gas are possible as well.

With the method according to the second embodiment, a secondary electron yield is increased by at least 15%. With a combined action of at least two gases of the group of SE-enhancement gases 637, even higher secondary electron yield is achieved, for example with an increase of a secondary electron yield of more than 30%, or even more than 50%. Thereby, a signal generated during ion beam inspection or ion beam milling is improved and a precision of an end-pointing is increased.

The disclosure is not limited to the embodiments and examples, but is also comprising variations, combinations, or modifications thereof. Other embodiments of the invention will be apparent to those skilled in the art from consideration of the specification and practice of the invention disclosed herein. The disclosure is further described in following clauses:
Clause 1: A method of ion beam scanning a semiconductor sample, comprising:
   - arranging an inspection or repair site (41) of a wafer (7) at a column axis (359) of an ion beam column(353),
   - starting a scanning operation of the ion beam (103) over the inspection or repair site (41),
   - providing at least two gases (637, 637.1, 637.2, 637.3) of a group of SE-enhancement gases by at least two individual gas nozzle (635.1, 635.2, 635.3) to the inspection or repair site (41), wherein the group of SE-enhancement gases comprises gases including:
   - a first gas (637.1) formed by an oxidizing or reducing agent selected to change a work function of a material comprised at a surface (15) of the wafer (7) at the inspection or repair site (41),
   - a second gas (637.2) formed by an inert gas, selected to neutralize a surface charging of the wafer (7) at the inspection or repair site (41), and
   - a third gas (637.3) formed by an aggressive cleaning agent, selected to chemically remove sputtered material from the surface (15) of the wafer (7).
Clause 2: The method of clause 1, comprising providing a third gas (637.3) of a group of SE-enhancement gases by a third individual gas nozzle (635.3).
Clause 3: The method of clause 1 or 2, wherein the first gas (637.1) is selected from a group of gases including Hydrogen, Oxygen, water vapor, H2O2, XeF2, NF3, nitric acid, N,N-dimethyl ethanamide, formic acid, ethanol, isopropanol, methyl nitro acetate, ammonia, ammonium Carbamate and nitro-ethanol.
Clause 4: The method of any of the clauses 1 to 3, wherein the second gas (637.2) is selected from a group of gases including Nitrogen, Neon, Xenon, Argon, Krypton and Helium.
Clause 5: The method of any of the clauses 1 to 4, wherein the third gas (637.3) is selected from a group of gases including XeF2, CI2, Bromine vapor, Iodine vapor, and water vapor.
Clause 6: The method of any of the clauses 1 to 5, wherein the at least two gases (637, 637.1, 637.2, 637.3) are selected based on a predetermined material composition at an inspection or repair site (41) of a wafer (7).
Clause 7: The method of any of the clauses 1 to 6, further comprising determining the material composition of a layer (75, 175, 177) at the inspection or repair site (41) from CAD information of the wafer (7).
Clause 8: The method of any of the clauses 1 to 7, further comprising adjustment of the at least two gases (637.1, 637.2,637.3) according to a material composition of a layer (75, 175, 177) of the wafer (7).
Clause 9: The method of any of the clauses 1 to 8, further comprising determining an end point of a milling operation and stopping the scanning operation of the ion beam (103) over the inspection or repair site (41).
Clause 10: An inspection and repair system (1), comprising:
   - an ion beam column (353),
   - a group of gas nozzles (635) with control valves (661) comprising at least a first and a second individual gas nozzle (635.1, 635.2, 635.3),
   - a control module (811) configured to control a gas supply of at least a first and a second individual gas (637) via the at least first and second gas nozzle (635.1, 635.2, 635.3),
   wherein the control module further comprises a memory storing a set of instructions and a processor configured to execute the set of instructions to cause the inspection and repair system (1) to perform a method of any of the clauses 1 to 9.
Clause 11: The inspection and repair system (1) of clause 10, further comprising a further gas nozzle (335) to provide a gas selected from a group of gases including PMPCS, Tungsten Hexacarbonyl, dicobalt octa carbonyl, molybdenum hexacarbonyl, and silazane.
Clause 12: The inspection and repair system (1) of clause 10 or 11, wherein the ion beam column (353) comprises a gas field ion source (349).

### List of reference numbers:

- 1: Ion beam inspection and Repair System
- 7: substrate or sample
- 15: surface of sample
- 17: second surface
- 19: surface of first layer
- 33: alignment fiducials
- 41: inspection or repair site
- 43: first trench
- 45: trench at alignment fiducial
- 47: second trench
- 49: deep trench
- 51: alignment fiducial
- 71: bulk material
- 73: bulk material
- 75.1...75.N: multi-layer stack
- 79: bulk material
- 81: repair location
- 103: Ion beam
- 105: focus point of ion beam
- 175: isolating layer
- 177: interconnecting layer
- 181: surface charging
- 183: escaping secondary electrons
- 185: captured secondary electrons
- 187: Secondary electron prevented from exit
- 189: redeposition
- 191: gas mediated work function modification
- 193: increased secondary electron extraction
- 195: increased secondary electron extraction
- 301: Source tip
- 303: heating wire
- 305: Mounting posts
- 307: Extractor electrode
- 309: Condenser lens
- 311: first multipole element
- 313: second multipole element
- 314: intermediate focus
- 315: aperture stop carrier
- 317: aperture stops
- 319: Beam blanker
- 321: Beam dump
- 323: third multipole element
- 325: fourth multipole element
- 327: fifth multipole element
- 329: objective lens
- 331: detector
- 333: secondary electron path
- 335: first gas nozzle
- 337: precursor gas
- 339: calibration sample
- 341.1: source gas nozzles
- 343: first source gas
- 345: second source gas
- 347: precision valves
- 349: gas field ion source
- 351: source chamber
- 353: ion beam column
- 355: sample enclosure or sample chamber
- 359: column axis
- 500: sample stage
- 635: gas nozzle
- 637: individual gas
- 637.1: first gas nozzle
- 637.2: second gas
- 637.3: third gas
- 647: charge neutralization
- 800: operation control unit
- 801: source control unit
- 803: image acquisition control unit
- 807: focusing control unit
- 811: inspection control module

## Claims

1. A method of ion beam scanning a semiconductor sample, comprising:
- arranging an inspection or repair site (41) of a wafer (7) at a column axis (359) of an ion beam column(353),
- starting a scanning operation of the ion beam (103) over the inspection or repair site (41),
- providing at least two gases (637, 637.1, 637.2, 637.3) of a group of SE-enhancement gases by at least two individual gas nozzle (635.1, 635.2, 635.3) to the inspection or repair site (41), wherein the group of SE-enhancement gases comprises gases including:
- a first gas (637.1) formed by an oxidizing or reducing agent selected to change a work function of a material comprised at a surface (15) of the wafer (7) at the inspection or repair site (41),
- a second gas (637.2) formed by an inert gas, selected to neutralize a surface charging of the wafer (7) at the inspection or repair site (41), and
- a third gas (637.3) formed by an aggressive cleaning agent, selected to chemically remove sputtered material from the surface (15) of the wafer (7).

2. The method of claim 1, comprising providing a third gas (637.3) of a group of SE-enhancement gases by a third individual gas nozzle (635.3).

3. The method of claim 1 or claim 2, wherein the first gas (637.1) is selected from a group of gases including hydrogen, oxygen, water vapor, H₂O₂, XeF₂, NF₃, nitric acid, N,N-dimethyl ethanamide, formic acid, ethanol, isopropanol, methyl nitro acetate, ammonia, ammonium carbamate and nitro-ethanol.

4. The method of claim 1 or claim 2, wherein the second gas (637.2) is selected from a group of gases including nitrogen, neon, xenon, argon, krypton and helium.

5. The method of claim 1 or claim 2, wherein the third gas (637.3) is selected from a group of gases including XeF₂, Cl₂, bromine vapor, iodine vapor, and water vapor.

6. The method of claim 3, wherein the second gas (637.2) is selected from a group of gases including nitrogen, neon, xenon, argon, krypton and helium.

7. The method of claim 6, wherein the third gas (637.3) is selected from a group of gases including XeF₂, Cl₂, bromine vapor, iodine vapor, and water vapor.

8. The method of any one of the preceding claims, wherein the at least two gases (637, 637.1, 637.2, 637.3) are selected based on a predetermined material composition at an inspection or repair site (41) of a wafer (7).

9. The method of any one of the preceding claims, further comprising determining the material composition of a layer (75, 175, 177) at the inspection or repair site (41) from CAD information of the wafer (7).

10. The method of any one of the preceding claims, further comprising adjustment of the at least two gases (637.1, 637.2,637.3) according to a material composition of a layer (75, 175, 177) of the wafer (7).

11. The method of any one of the preceding claims, further comprising determining an end point of a milling operation and stopping the scanning operation of the ion beam (103) over the inspection or repair site (41).

12. An inspection and repair system (1), comprising:
- an ion beam column (353),
- a group of gas nozzles (635) with control valves (661) comprising at least a first and a second individual gas nozzle (635.1, 635.2, 635.3),
- a control module (811) configured to control a gas supply of at least a first and a second individual gas (637) via the at least first and second gas nozzle (635.1, 635.2, 635.3),
wherein the control module further comprises a memory storing a set of instructions and a processor configured to execute the set of instructions to cause the inspection and repair system (1) to perform a method of claim 1.

13. The inspection and repair system (1) of claim 12, further comprising a further gas nozzle (335) to provide a gas selected from a group of gases including PMPCS, Tungsten Hexacarbonyl, dicobalt octa carbonyl, molybdenum hexacarbonyl, and silazane.

14. The inspection and repair system (1) of claim 12, wherein the ion beam column (353) comprises a gas field ion source (349).

15. One or more machine-readable hardware storage devices comprising instructions executable by one or more processing devices to perform the method of claim 1.
